# EUROPEAN PATENT SPECIFICATION

(11) **EP 1 153 313 B1**
(45) Date of publication and mention of the grant of the patent: **09.04.2003**
(21) Application number: 99900856.8
(22) Date of filing: 20.01.1999
(51) Int. Cl.: G01R 33/12

(54) **APPARATUS AND METHOD FOR EVALUATING A CONDITION OF A MAGNETIC CIRCUIT OF AN ELECTRIC MACHINE**
VERFAHREN UND VORRICHTUNG ZUM AUSWERTEN DES ZUSTANDES EINES MAGNETISCHEN KREISES EINER ELEKTRISCHEN MASCHINE
APPAREIL ET PROCEDE PERMETTANT D'EVALUER L'ETAT D'UN CIRCUIT MAGNETIQUE D'UNE MACHINE ELECTRIQUE

(43) Date of publication of application: 14.11.2001
(73) Proprietor: HYDRO-QUEBEC, Montréal Québec H2Z 1A4 (CA)
(72) Inventor: BOURGEOIS, Jean-Marc, Longueuil, Québec J4M 1Y4 (CA); LALONDE, François, Varennes, Québec J3X 1C4 (CA)
(74) Representative: Habasque, Etienne Joel Jean-François
(86) International application number: CA9900043
(87) International publication number: WO00043799

(56) References cited:
- EP-A- 0 421 783
- GB-A- 2 044 936
- US-A- 4 215 310
- US-A- 5 341 095
- ANONYMOUS: "High Precision Stator/Rotor Quality" IBM TECHNICAL DISCLOSURE BULLETIN, vol. 26, no. 10A, pages 4893-4894, XP002117552 New York, US

## Description

### FIELD OF THE INVENTION

This invention relates in general to testing devices and methods, and more particularly to an apparatus and a method for evaluating a condition of a magnetic circuit of an electric machine. The apparatus and method can be used to detect and spot quickly possible defects on magnetic circuits of stators of large alternators. They are also applicable to motors and transformers.

### BACKGROUND

Generally, the magnetic circuit of an electric machine consists of a piling up assembly of metal laminations. To prevent overheating of the laminations caused by the flow of Eddy currents, the laminations are insulated from each other by means of insulating varnish or other materials. Defects to which reference is herein made are caused by short circuits between the metal laminations. In the case of alternators' stators, such defects can be caused for example by a metallic piece (e.g. a bolt) detaching and causing damages to the face of the stator, a breakdown between the winding under voltage (13kV) and the stator, or the wear of the varnish. These defects must be located.

One method of the prior art consists in a visual inspection. This basic method is still used and allows to locate some apparent defects. This method is subjective as it depends on the skills of the person carrying it out. It cannot be used to detect defects in the notches or between the metal strips of a stator. This method is also difficult to carry out with a rotor in place.

Another method of the prior art consists in a magnetization test. In this method, an intense magnetic flux φt (≈80% of the nominal flux) is generated in the stator ring by means of temporary excitation windings mounted on the stator for this purpose. An infrared camera observes the inner face of the stator to detect the hot spots. This method is qualitative and cannot be used to detect defects on only a portion. It requires a powerful external excitation source, and the excitation windings are important. The installation and test times are long, it requires several workers and is impracticable with the rotor in place.

Another method of the prior art consists in an electromagnetic core imperfection detection test (ELCID). In this method, a low magnetic flux φt (≈4% of the nominal flux) is induced in the stator ring by means of a temporary excitation winding mounted on the stator for this purpose. A measurement probe explores the Inner face of the stator to detect anomalies. In this method, the preparation of the stator is similar to the magnetization test, except that It Involves a less powerful source and a more modest temporary excitation winding. This method is quantitative. Nevertheless, it is more or less suitable to detect defects between the metal laminations, it still requires an external excitation source and the mounting of an excitation winding, and several workers. Furthermore, the installation time Is long and the test time is in the average.

Both last mentioned methods involve high costs, and may provide inaccurate results.

From US patent No. 4,215,310 (Schwerer, III), a magnetic testing method and apparatus are already known in which a test probe carrying excitation and pickup coils is placed against a test piece of magnetic and/or electrically conductive material. Properties of the test piece are determined by applying a controlled alternating drive current to the excitation coil so as to produce an AC voltage in the pickup coil and measuring the drive current applied to the excitation coil when the time-integral of the voltage induced in the AC pickup coil corresponds to zero magnetic flux in the gaps.

From US patent No. 6,341,095 (Shelton et al.), a dynamoelectric machine stator test device is already known in which a coil and a pair of magnets are moved over a length of the stator to detect stator axial currents.

### SUMMARY

One object of the present invention is to provide an apparatus and a method for evaluating a condition of a magnetic circuit of an electric machine, which is simple, accurate and easy to use.

A subsidiary object of the invention is to provide such an apparatus and a method which do not require the mounting and installation of excitation windings onto the electric machine, and is practicable with a rotor and the stator windings in place.

A subsidiary object of the invention is to provide such an apparatus and a method which are cost competitive with respect to the prior art methods, provide quantitative and repeatable results.

The apparatus according to the present invention comprises a probe having a magnetic transverse portion, first and second spaced apart magnetic prong portions projecting from the transverse portion on one side thereof, an excitation winding wound around the first prong portion, and a measurement winding wound around the second prong portion, the prong portions having respective end faces adapted to match a pair of teeth projecting from a face of the magnetic circuit, with the end faces in registry with the teeth. An excitation source is electrically connected to the excitation winding. A current measuring means measures a current flowing in the excitation winding. A voltage measuring means measures a voltage across the measurement winding. A calculating means calculates a resulting power from the current and the voltage measured by the measuring means, the resulting power being indicative of the condition of a test zone formed of the teeth of the pair in front of the probe and a portion of the magnetic circuit extending therebetween.

The method according to the invention comprises the steps of: (a) positioning a probe in front of a pair of the teeth of the magnetic circuit, the probe having a magnetic transverse portion, first and second spaced apart magnetic prong portions projecting from the transverse portion on one side thereof, an excitation winding wound around the first prong portion, and a measurement winding wound around the second prong portion, the prong portions having respective end faces adapted to match the teeth of the pair in front of the probe with the end faces in registry with the teeth of the pair; (b) exciting the excitation winding to induce a magnetic flux in a test zone formed of the teeth of the pair and a portion of the magnetic circuit extending therebetween; (c) measuring a current flowing in the excitation winding; (d) measuring a voltage across the measurement winding; and (e) calculating a resulting power from the current and the voltage, the resulting power being indicative of the condition of the test zone.

The invention is particularly advantageous in that it requires no installation of special excitation circuits around the magnetic circuit of the electric machine to be tested. Immediate interpretation of the results can be achieved with the invention. It takes a relatively short time to inspect the magnetic circuit using the invention, in comparison with the prior art methods. The invention provides simple, accurate and easy to use apparatus and method.

### BRIEF DESCRIPTION OF THE DRAWINGS

A detailed description of preferred embodiments of the invention will be given hereinbelow with reference to the following drawings, in which like numbers refer to like elements:
Figure 1 is a schematic diagram of an apparatus according to the invention, to test the magnetic circuit of a stator;
Figure 2 is a simplified equivalent electrical circuit of the apparatus with the magnetic circuit as shown in Figure 1;
Figure 3 is a schematic diagram of an analog excitation and measurement circuit for the apparatus according to the invention;
Figure 4 is a schematic diagram of a digital excitation and measurement circuit for the apparatus according to the invention;
Figure 5 is a perspective view of the probe of the apparatus according to the invention; and
Figure 6 is an enlarged partial view of one end face of the probe shown in Figure 5.

### DETAILED DESCRIPTION OF PREFERRED EMBODIMENTS

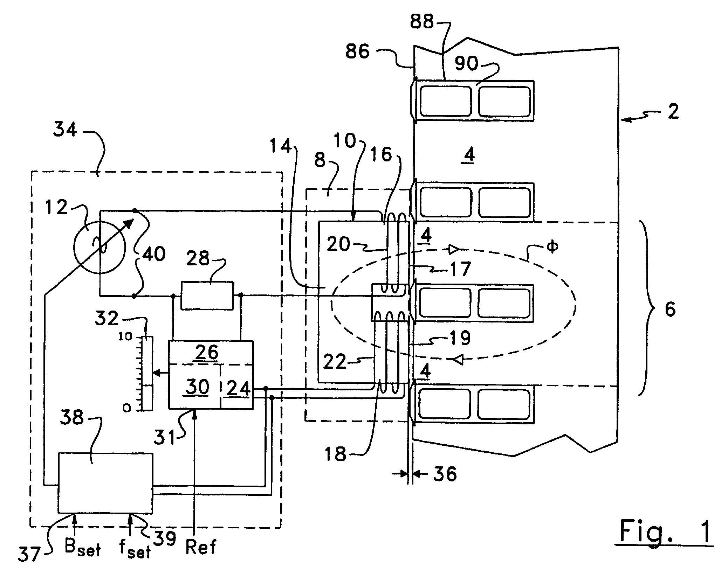

Referring to Figure 1, there is shown a schematic diagram of an apparatus according to the invention, to evaluate the condition of the magnetic circuit of a stator 2 (the Figure shows a cross-sectional partial view of the stator 2) having a face 86 provided with a series of spaced apart projecting teeth 4. Such a magnetic circuit is generally formed of an assembly of superimposed laminations of magnetic material, each coated with an electrically insulating material.

The method according to the invention consists in inducing locally a magnetic flux φ in a portion 6 of the magnetic circuit to be tested, by means of the apparatus according to the invention, which comprises a probe 8 formed of a C-shaped magnetic circuit 10. The same magnetic circuit 10 is also used for detection purposes. In operation, the probe 8 is positioned in front of a pair of teeth 4 of the magnetic circuit of the stator 2. The magnetic circuit 10 of the probe 8 and the test zone 6 of the stator 2, which is magnetically coupled with the probe 8, form a magnetic circuit in test. The magnetic circuit 10 of the probe 8 has a transverse portion 14, and first and second spaced apart prong portions 16, 18 projecting from the transverse portion 14 on one side thereof. The prong portions 16, 18 have end faces 17, 19 adapted to match the pair of teeth 4 in the test zone 6, with the end faces 17, 19 in registry with the teeth 4.

The apparatus has electronics 34 for the generation and the processing of the signals. The electronics 34 include an excitation source 12 connected to an excitation winding 20 wound around the first prong portion 16 of the probe 8, to induce the magnetic flux φ in the test zone 6. The probe 8 has a measurement winding 22 wound around the second prong portion 18, to measure the level of real flux induced in the magnetic circuit in test. The apparatus is provided with a voltage measurement circuit 24, to measure a voltage V(t) across the measurement winding 22. The voltage V(t) so measured reflects the induced flux since V(t)=mdφ/dt, where m is the number of turns of the measurement winding 22 around the second prong portion 18. A current measurement circuit 26 measures the current I(t) required to induce this flux. This can be achieved using a shunt 28 or any other suitable method and device for this purpose. A calculating circuit 30 measures a resulting power from the current and the voltage measured by the measuring circuits 24, 26. The resulting power can be calculated using the instant power formula P(t)=V(t)·I(t). A reading corresponding to the resulting power can be displayed using a meter 32 connected to the calculating circuit 30.

in the absence of defects in the test zone 6, the resulting power corresponds to the normal losses in the whole magnetic circuit in test. The normal losses herein referred to are the normal iron losses. They consist of hysteresis losses Wₕ and Eddy current losses W_{F}. These losses are generally expressed in Watt/cm³ and sometimes in Watt/Kg. The hysteresis losses are given by Wₕ=ηfBⁿ where η is a coefficient associated to the quality of the laminations involved in the process, f is the excitation frequency, and B is the maximal induction raised to the power of n, 1<n≤2. The Eddy current losses are given by W_{F}=(e/ρ)f²B² where e is the thickness of the laminations involved in the process, p is the resistivity of the materials, f is the excitation frequency, and B is the maximal induction raised to the power of 2. The apparatus measures the total losses Wₜ=Wₕ+W_{F}. With the present configuration of the magnetic circuit in test, the total losses can be calculated with the relation Wₜ=Kf^{1.5}B^{1.9} where K is a coefficient that takes the quality of the laminations (thickness, resistivity, hysteresis factor, etc.) into account. The two exponents can be different on other configurations.

In the presence of defects in the test zone 6, an increase of the value of the resulting power can be observed, thus of the losses. In the presence of defects (e.g. short circuit between the laminations) in the magnetic circuit in test, the measured power increases since these defects give rise to additional Eddy currents. The apparatus thus measures Wₜ=Wₕ+W_{F}+W'_{F} where W'_{F} represents the additional losses caused by the currents flowing in the defects (assimilable to Eddy currents).

Thus, the resulting power is indicative of the condition of the test zone 6 formed of the teeth 4 of the pair involved in the process and a portion of the magnetic circuit extending therebetween.

By carrying out the difference between the typical losses without the presence of defects and the losses reported by the meter 32, there is obtained a value linked to the gravity of the possible defects. This operation can be achieved, for example, mentally (the user compares the reading with preestablished records), by calibrating the "0" of the meter 32 prior to the test, or by devising the calculating circuit 30 to automatically take the typical losses into account during the calculations. In such a case, the calculating circuit 30 has an input 31 to receive a signal REF indicative of the typical losses.

The difference between the measured power and the typical power lets appear only the term W'_{F} linked to the scale of the defect. The issue consists in determining the value of the losses said to be "normal" in order to obtain a reading close to zero when there are no defects. Two ways are possible. A first way consists in determining the normal losses (probe 8 and test zone 6) by calculations. In regard to the electric machine, the various coefficients characteristic of the laminations of the stator in test, the thickness of the laminations, the effective volume in test, the various induction levels in this volume, the parasitic effects such as the expansion coefficient or the leakage flux, must all be known. The margin of error on the final value is likely to be important. In regard to the probe 8, it is a constant that can be determined in laboratory. A second way consists in statistically determining the "normal" losses. Ideally, measurements will be achieved at the starting up of the electric machine. There is thus obtained a representative value (average of the distribution with a low standard deviation) of the losses for this machine. It is the zero, the absolute reference of its background history. Measurements can also be achieved on a machine having a given lifetime but the state of which is reputed to be good. In this case, the distribution could be slightly more spread out with a higher average if there has been an aging. This relative zero can nevertheless be used as a reference for the follow-up and allows to detect the apparition of defects. On a poor condition machine, where the zero has never been determined, the reference will be established by achieving measurements in a zone considered as acceptable. If no reliable reference can be established, there remains the solution of globally analysing, by statistical methods, the results of a large number of measurements on the machine in order to bring out the defects despite the possibly important standard deviation, the bimodal distribution, etc.

To become independent from the residual gap 36 between the end faces 17, 19 of the prong portions 16, 18 and the teeth 4 of the magnetic circuit, the excitation source 12 is preferably adjusted to obtain a flux φ of constant amplitude, thus a V(t) across the measurement winding 22 of constant amplitude. This adjustment can be manual or automated.

Since the losses are directly linked to the level of induction B, it is important to know the latter. For this purpose, it is either possible to normalize (by calculation) the measured losses at some level towards a reference level of induction, or to operate at a constant level of induction (to render the measurements immediately comparable).

In practice, the induction changes can result from two principal sources. The first principal source is the variations of the gap 36 between the end faces 17, 19 of the prong portions 16, 18 and the teeth 4 in the test zone 6. Without correction, these variations are likely to cause a change in the level of induction each time the probe 8 is applied on the magnetic circuit of the electric machine. The second principal source is the reluctance of the magnetic circuit of the electric machine in test. From machine to machine, the magnetic circuit does not necessarily have the same depth, the same gauge between the teeth 4, and is not formed of materials having identical magnetic properties. Without correction, these variations cause a change in the level of induction from one machine to the other.

In the embodiment of the apparatus shown in Figure 1, there is provided a control circuit 38 to control the voltage of the AC signal produced by the excitation source 12 as a function of the voltage V(t) across the measurement winding 22. The purpose of the control circuit 38 is to automatically control the induction of the probe 8 based on the general equation B=V/mSf. Thus, by measuring the instant voltage V across the measurement winding 22, the induction B can be known at the level of this branch (the prong portion 18) of the magnetic circuit in test since the number of turns m of the measurement winding 22, the section S of the magnetic circuit in test (the section of the second prong portion 18) and the excitation frequency f are known. The voltage of the excitation source 12 will be controlled consequently to meet an induction setting Bₛₑₜ for example by way of a comparison. The control circuit 38 may be provided with an input 37 to receive the induction setting signal Bₛₑₜ and, in the case where the excitation source has a controllable frequency, an input 39 to receive a frequency setting signal fₛₑₜ.

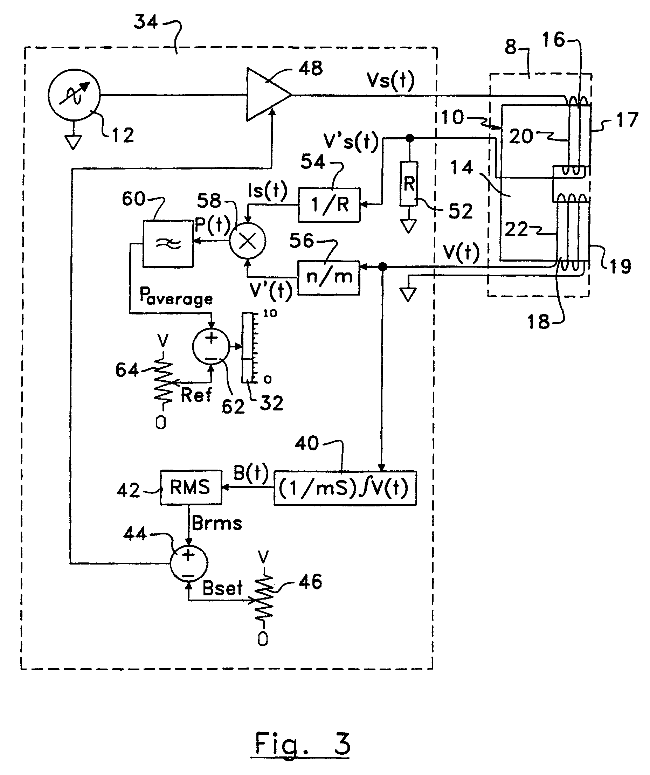

Referring to Figure 3, there is shown a possible analog version of the electronics 34 of the apparatus. In this version, the excitation source 12 produces an AC signal having a given voltage and an adjustable frequency. The control circuit is embodied by an integrator 40, a RMS (root-means-square) circuit 42, a differential circuit 44, a potentiometer 46 and a gain controllable amplifier 48.

The integrator 40 is connected to the measurement winding 22 and performs the function (1/Sm)∫V(t) where S is the section of the magnetic circuit 10 under the measurement winding 22, m is the number of turns of the measurement winding 22 around the prong portion 18 and V(t) is the voltage across the measurement winding 22. This function provides the density of magnetic flux B(t) in the magnetic circuit in test, in the form of a voltage. This voltage is transmitted to the RMS circuit 42 that provides a rms value of the flux density Bᵣₘₛ, in the form of a voltage. This voltage is transmitted to the differential circuit 44 that produces a control signal proportional to the difference between the voltage representing Bᵣₘₛ and a voltage representing the desired induction Bₛₑₜ in the circuit in test. The voltage representing the desired induction Bₛₑₜ can be produced using a simple potentiometer 46 that permits an adjustment. The control signal is transmitted to a gain controlled amplifier 48 connected between the excitation source 12 and the excitation winding 20.

The excitation winding 20 is shunted by means of a resistor 52 having a low resistance R. The voltage V'ₛ(t) across the resistor 52 is applied to a 1/R gain circuit 54, to produce a voltage signal representing the instant current I(t) flowing in the excitation winding 20. The voltage V(t) across the measurement winding 22 is applied to a n/m gain circuit 56 to produce a voltage signal V'(t) representing the instant voltage across the inductive part of the excitation winding 20, n, m being the number of turns of the excitation and measurement windings 20, 22, respectively. Both voltage signals produced by the gain circuits 54, 56 are transmitted to a multiplier 58 that produces a voltage signal representing the instant power P(t) in the magnetic circuit in test. The voltage signal produced by the multiplier 58 is passed into a low-pass filter 60 to obtain a voltage signal representing the average power P_{average}, indicative of the losses in the magnetic circuit in test. This filtered voltage signal is transmitted to a differential circuit 62 that subtracts a voltage representing the typical losses of the magnetic circuit in test (i.e. no defects), and produces a signal indicative of power losses caused by possible defects in the magnetic circuit in test (i.e. in the test zone 6 as shown in Figure 1). The typical losses can be adjusted using a potentiometer 64.

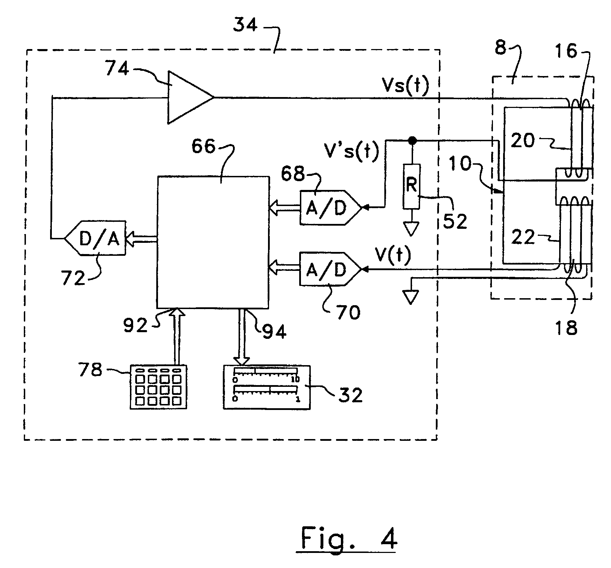

Referring to Figure 4, there is shown a possible digital version of the electronics 34 of the apparatus. In this version, all the functions performed by the measurement, calculating and control circuits and the excitation source, are conveniently provided by a circuit arrangement based on a microcontroller 66. The microcontroller 66 is provided with analog-to-digital converters 68, 70 to convert the voltages V'ₛ(t) and V(t) into digital signals readable by the microcontroller 66. The excitation source is provided by a digital-to-analog converter 72 connected to the microcontroller 66, and an amplifier 74. The microcontroller 66 has an input 92 connectable to a keypad 78 that can be used to set the desired induction level for the probe 8 and the operating frequency of the excitation source, in addition to various other operating parameters of the apparatus like the basic losses reference, the probe type (number of turns of the windings 20, 22), etc. The microcontroller 66 has an output 94 connectable to a meter 32 used to provide a reading of the losses calculated by the microcontroller 66, thus a display of the gravity of the defect, as well as other data at the request of the user.

The microcontroller 66 is thus programmed to achieve all the necessary calculations, including the control of the flux density.

With the calculation power of a microcontroller, the performance of the apparatus can be improved in several ways, e.g. the automatic learning of the basic loss values, the storage and selection of these values in relation with identified electric machines, the display of various parameters like the induction level, the measured current, statistics over a series of measurements, the storage of the data for later analysis.

By using V(t) across the measurement winding 22 instead of the voltage of the AC signal produced by the excitation source 12, the copper losses in the excitation winding 20 are eliminated from the loss calculations. This thus improves the sensitivity of the apparatus. In a same fashion, high quality magnetic materials and a proper geometry should be chosen in the construction of the probe 8 in order to minimize the losses in the probe 8 itself.

The calculation of the losses takes into account the losses in the test zone 6 and also in the probe 8 itself since it is an intrinsic part of the whole magnetic circuit in test. The apparatus will be all the more sensitive that the fixed losses will be minimized. On the side of the stator, there are always basic losses that are evaluated as hereinabove described, to eliminate them from the measurement. On the side of the probe 8, there are losses in the magnetic circuit 10 (iron losses) and losses in the windings 20, 22 (copper losses).

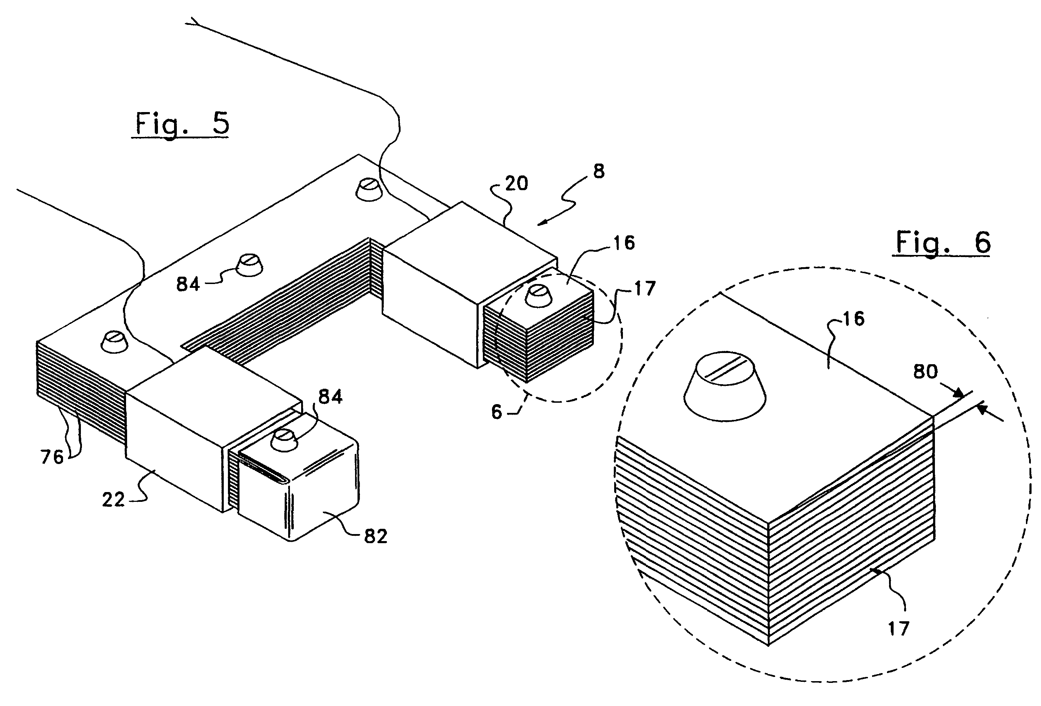

Referring to Figure 5, there is shown an embodiment of the probe 8. The probe is made of high quality, electrically insulated and piled-up laminations 76, as for the stator. The quality of the laminations 76 is chosen to minimize the (iron) losses in the probe 8 and to obtain a magnetic path having the lowest possible reluctance.

This is achieved by using thin laminations 76 of high permittivity, of low hysteresis factor, of high resistivity, etc. It is also a matter of proper geometry, i.e. of short magnetic circuit 10, of minimal volume, of optimal angle on the end faces 17, 19 in magnetic contact with the stator to minimize the gap 36 (as shown in Figure 1), of concentrated windings 20, 22 to minimize the leakage flux, etc.

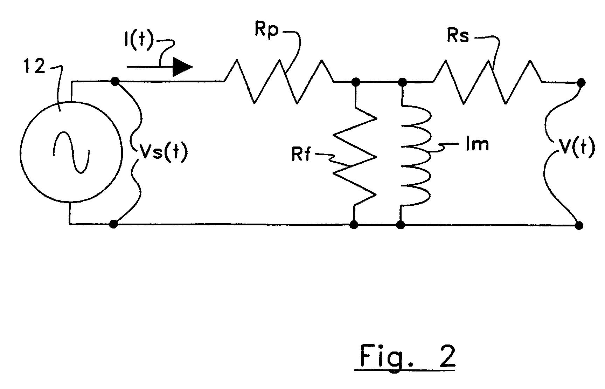

Referring to Figure 2, there is shown a simplified equivalent circuit of the apparatus.

To minimize the copper losses, conductors of very low resistance Rₚ are preferably used. The calculation of the losses can be carried out with the relation Wₜ=Vₛ(t)·I(t) where Vₛ(t) is the voltage of the AC signal produced by the excitation source 12, and I(t) is the current flowing in the excitation winding 20. In such a case, the iron losses represented by R_{f}, and the copper losses, represented by Rₚ, of the probe 8 are taken into account. There are no copper losses in the secondary winding 22 if the circuit is open. To calculate only the iron losses, it would be necessary to not use the voltage Vₛ(t) of the source 12 but the voltage across R_{f}. This point is not physically accessible. However, this voltage corresponds exactly (close to the ratio of turn) to the output voltage V(t) if the winding 22 of the secondary is open. Thus, Wₜ=V(t)·I(t) corresponds solely to the iron losses in an ideal circuit as the one shown in Figure 2.

Referring to Figure 1, the frequency setting via the control circuit 38 allows to control the frequency f of the excitation source 12. This feature is advantageous for at least two reasons. In the present electric machines, the range of use spreads from 50 Hz to some kilohertz. As the frequency increases, the Eddy current losses (f²) dominate over the hysteresis losses (proportional to f). But, the searched defects are seen as Eddy current losses. The sensitivity of the apparatus is thus increased. The construction of the probe 8 is easier at high frequency. The excitation winding 20 has less turns, and the magnetic circuit 10 requires less metal.

The dimensions of the probe 8 are defined by certain considerations. Preferably, the length of the magnetic path in the probe 8 is minimized. The same applies to the volume of metal of the probe 8. The probe 8 should match with the teeth 4 of the stator in test. The center-to-center distance between the prong portions 16, 18 of the probe 8 is preferably the same as the center-to-center distance between the teeth 4 of the stator. It is also preferable that each prong portion 16, 18 of the probe 8 be slightly narrower than the width of a tooth 4. This facilitate the alignment and provides a better magnetic coupling. The teeth 4 are normally formed by groups of laminations, the groups being separated by ventilation channels. The height of a tooth is in the range of 4 to 5 cm, whereas the height of a ventilation channel is in the range of 5 to 6 mm. The teeth 4 are also separated by vertical notches 88 receiving the power windings 90. In regard to the thickness of the probe 8, there are two limits. The probe 8 could be of the same thickness as a tooth 4. In this case, it would be only possible to locate the defective tooth 4. The probe 8 could be very thin (a few laminations). In this case, the position of the defect could be located within the tooth 4 itself. However, this accuracy considerably increases the inspection time and makes the alignment of the probe 8 harder. Preferably, for standard stator configurations, the probe 8 has a thickness that represents the third of the height of a tooth 4. Portability and ease of use are also other factors that can be taken into account.

The gap 36 should be minimized and maintained the most constant as possible. If the gap 36 is too important, there is no longer magnetic coupling with the stator. Thus, defects cannot be located. However, this situation is easily detectable by the apparatus since the current of the excitation source 12 becomes abnormally high. In the normal range of operation, in the order of the millimeter, the coupling is adequate. Normally, the part of the face 86 of the stator 2 involved in the process is not flat; it is a tiny portion (≈20 cm) of a circle (≈10 m of diameter). To improve the magnetic coupling and reduce the gap 36 between the end faces 17, 19 of the prong portions 16, 18 and the teeth 4 in the test zone 6, the end faces 17, 19 are preferably machined to match the curvature of the stator 2.

Referring to Figure 6, since the diameter of the stator 2 is large in comparison with the spacing of the prong portions 16, 18, it is not necessary to machine the end faces 17, 19 in arcs of a circle; a simple angle 80 is sufficient.

Referring to Figure 5, the residual gap 36 thus principally results from the roughness of the teeth surfaces, the presence of surface paint and the quality of the alignment of the probe 8. A simple manner to minimize the variations of the gap 36 is to impose a known gap. This can be achieved by providing the end faces 17, 19 of the probe 8 with spacers 82 (only the spacer 82 for the end face 19 is shown in the Figure, for clarity reasons) of known thickness, e.g. 0.5 mm layers of Teflon. Thus, the effect of the gap 36 is controlled and the sliding of the probe 8 is even facilitated. The spacers 82 can be attached to the probe 8 in any suitable manner. For example, each spacer 82 can be formed of a single Teflon sheet folded on each prong portion 16, 18 of the probe 8. The bolts 84 used to hold the laminations 76 together can be used to also hold the Teflon sheets. The assembly of laminations 76 of the probe 8 could also be wrapped in a plastic coating to hold them together, protect them and provide at the same time the spacers 82.

It should be noted that the previous explanations and equations are valid insofar as the magnetic circuit is not saturated. The fact of operating at a fixed and controlled induction overcomes this problem.

While embodiments of this invention have been illustrated in the accompanying drawings and described above, it will be evident to those skilled in the art that changes and modifications may be made therein without departing from the essence of this invention. For example, the probe 8 may be provided with additional prong portions (not shown) to cover several teeth 4 at a time. The shape of the probe 8 can be changed, insofar as it suits the above-described functions. The spacers 82 may be used to provide the angle 80 instead of the end faces 17, 19. The probe 8 can be applied to two adjacent teeth 4 or not (i.e. with other teeth 4 in between). The probe 8 can be formed for example of metallic powder. All such modifications or variations are believed to be within the scope of the invention as defined by the claims appended hereto.

## Claims

1. An apparatus for evaluating a condition of a magnetic circuit of an electric machine, the magnetic circuit having a face (86) provided with a series of spaced apart projecting teeth (4), the apparatus comprising:
a probe (8) having a magnetic transverse portion (14), first and second spaced apart magnetic prong portions (16,18) projecting from the transverse portion (14) on one side thereof, an excitation winding (20) wound around the first prong portion (16), and a measurement winding (22) wound around the second prong portion (18), the prong portions (16, 18) having respective end faces (17, 19) adapted to match a pair of said teeth (4) with the end faces (17, 19) in registry with the teeth (4) of said pair;
an excitation source (12) electrically connected to the excitation winding (20);
current measuring means (26) for measuring a current flowing in the excitation winding (20);
voltage measuring means (24) for measuring a voltage across the measurement winding (22); and
calculating means (30) for calculating a resulting power from the current and the voltage measured by the measuring means (24, 26), the resulting power being indicative of the condition of a test zone (6) formed of the teeth (4) of said pair and a portion of the magnetic circuit extending therebetween.

2. The apparatus of claim 1, wherein the excitation source (12) has an output to produce an AC signal having a voltage, the apparatus further comprising a control means (38) for controlling the voltage of the AC signal as a function of the voltage across the measurement winding (22).

3. The apparatus of claim 2, wherein the control means (38) comprise:
comparing means (44) for comparing an induction B in the probe (B) with an induction setting, the induction B being expressed as B=V/mSf where V is the voltage across the measurement winding (22), m is a number of turns of the measurement winding (22) around the second prong portion (18), S is a section of the second prong portion (18), and f is a frequency of the AC signal; and
adjusting means (46) responsive to the comparing means (44), for adjusting the voltage of the AC signal so that the induction B corresponds to the induction setting.

4. The apparatus of claim 1, wherein the calculating means (30) comprise means (62) for subtracting a reference power loss value from the resulting power.

5. The apparatus of claim 1, further comprising a meter (32) connected to the calculating means (30) to display a reading representative of the resulting power.

6. The apparatus of claim 1, wherein the portions (14, 16, 18) of the probe (8) comprise a number of superimposed laminations (76) electrically insulated from each other.

7. The apparatus of claim 1, wherein the end faces (17, 19) of the prong portions (16, 18) have a center-to-center distance corresponding substantially to a center-to-center distance between the teeth (4) of said pair.

8. The apparatus of claim 1, wherein the teeth (4) have a predetermined width, and the end faces (17, 19) of the prong portions (16, 18) have a width smaller than the width of the teeth (4).

9. The apparatus of claim 1, wherein the end faces (17, 19) of the prong portions (16, 18) are provided with electrically insulating spacers (82) adapted to abut against the teeth (4) of said pair to fix a gap thickness between the probe (8) and the teeth (4) of said pair when the probe (8) is In operating position.

10. The apparatus of claim 1, wherein the portions (14, 16, 18) of the probe (8) generally have together a C-shaped configuration.

11. The apparatus of claim 1, wherein the end faces (17, 19) of the prong portions (16, 18) are beveled with respect to main axes of the prong portions (16, 18).

12. The apparatus of claim 1, wherein the measuring and calculating means (24, 26, 30) are provided by a circuit comprising:
a first analog to digital converter (68) having an input connected to the excitation winding (20), and an output;
a second analog to digital converter (70) having an input connected to the measurement winding (22), and an output: and
a microcontroller (66) having first and second inputs connected respectively to the outputs of the analog to digital converters (68, 70), and an output to produce a signal representative of the resulting power.

13. The apparatus of claim 2, wherein the measuring and calculating means (24, 26, 30), the excitation source (12) and the control means (38) are provided by a circuit comprising:
a first analog to digital converter (68) having an input connected to the excitation winding (20), and an output;
a second analog to digital converter (70) having an input connected to the measurement winding (22), and an output;
a microcontroller (66) having first and second inputs connected respectively to the outputs of the analog to digital converters (68, 70), a third input to receive setting signals, a first output to produce a signal representative of the resulting power, and a second output to produce a digital signal representative of the AC signal; and
a digital to analog corwerter and amplifier circuit arrangement (72, 74), having an input connected to the second output of the microcontroller (66), and an output to produce the AC signal.

14. The apparatus of claim 13, further comprising:
a meter (32) connected to the first output of the microcontroller (86) to display a reading representative of the resulting power; and
a keypad (78) connected to the third Input of the microcontroller (66), to generate the setting signals.

15. A method for evaluating a condition of a magnetic circuit of an electric machine, the magnetic circuit having a face (86) provided with a series of spaced apart projecting teeth (4), the method comprising the steps of:
positioning a probe (8) in front of a pair of said teeth (4), the probe (8) having a magnetic transverse portion (14), first and second spaced apart magnetic prong portions (16, 18) projecting from the transverse portion (14) on one side thereof, an excitation winding (20) wound around the first prong portion (16), and a measurement winding (22) wound around the second prong portion (18), the prong portions (16, 18) having respective end faces (17, 19) adapted to match the teeth (4) of said pair with the end faces (17, 19) in registry with the teeth (4) of said pair;
exciting the excitation winding (20) to Induce a magnetic flux in a test zone (6) formed of the teeth (4) of said pair and a portion of the magnetic circuit extending therebetween;
measuring a current flowing in the excitation winding (20);
measuring a voltage across the measurement winding (22); and
calculating a resulting power from the current and the voltage, the resulting power being Indicative of the condition of the test Zone.

16. The method of claim 15, further comprising the step of:
comparing the resulting power with a reference power value to determine a defect condition in the test zone (6).

17. The method of claim 16, wherein the reference power value is determined by calculating a typical power to be expected as a function of physical characteristics of the magnetic circuit and the probe (8).

18. The method of claim 16, wherein the reference power value is determined by performing the method before a first use of the magnetic circuit.

19. The method of claim 15, wherein the steps are repeated for all the teeth (4) of the magnetic circuit to locate possible defective portions thereof.

20. The method of claim 19, wherein the excitation source (12) is adjusted to induce a magnetic flux having a constant amplitude in each test zone (6).

## Patentansprüche

1. Vorrichtung zur Auswertung des Zustandes eines Magnetkreises einer elektrischen Maschine, wobei der Magnetkreis eine Fläche (86) aufweist, die mit einer Serie von zueinander beabstandeten, vorspringenden Zähnen (4) versehen ist, wobei die Vorrichtung aufweist:
eine Sonde (8) mit einem magnetischen Querabschnitt (14), erste und zweite zueinander beabstandete magnetische Klauen- bzw. Gabelabschnitten (16, 18), die von dem Querabschnitt (14) auf einer Seite derselben wegstehen, eine Erregerwicklung (20), die um den ersten Klauenabschnitt (16) gewickelt ist, mit einer Messwicklung (22), die um den zweiten Klauenabschnitt (18) gewickelt ist, wobei die Klauen- bzw. Gabelabschnitte (16, 18) entsprechende Seitenflächen (17, 19) aufweisen, die so ausgelegt sind, dass sie auf das Paar von Zähnen (4) passen, wobei die Seiten- bzw. Endflächen (17, 19) in Deckung mit den Zähnen (4) des Zahnpaares stehen; mit einer Erregerquelle (12), die elektrisch mit der Erregerwicklung (20) verbunden ist;
eine Strommesseinrichtung (26) zur Messung des Stromes, der in der Erregerwicklung (20) fließt;
eine Spannungsmesseinrichtung (24) zur Messung der Spannung über der Messwicklung (22);
eine Berechnungseinrichtung (30) zur Berechnung der resultierenden Leistung aus dem Strom und der Spannung, welche durch die Messeinrichtungen (24, 26) gemessen werden, wobei die resultierende Leistung indikativ ist für den Zustand einer Testzone (6), die aus den Zähnen (4) des Zahnpaares und einem Teil des Magnetkreises gebildet sind, welcher sich zwischen Letzteren erstreckt.

2. Vorrichtung nach Anspruch 1, bei welcher die Erregerquelle (12) einen Ausgang zur Abgabe eines AC-Signales mit einer Spannung aufweist, wobei die Vorrichtung weiterhin eine Steuer- bzw. Kontrolleinrichtung (38) zur Kontrolle der Spannung des AC- bzw. Wechselstromsignales als Funktion einer Spannung über der Messwicklung (22) aufweist.

3. Vorrichtung nach Anspruch 2, bei welcher die Kontrolleinrichtung (38) aufweist:
eine Komperatoreinrichtung (44) zum Vergleichen einer Induktion (B) in der Probe (8) mit einer Induktionseinstellung, wobei die Induktion (B) ausgedrückt wird als B=V/mSf, wobei V die Spannung an der Messwicklung (22) ist,
m die Zahl der Wicklungen der Messwicklung (22) um den zweiten Klauenabschnitt (18) und
S ein Abschnitt des zweiten Klauenabschnitts (18) ist und f die Frequenz des Wechselstromsignals darstellt;
eine Einstelleinrichtung (46), die auf die Komperatoreinrichtung (44) anspricht zur Einstellung der Spannung des Wechselstromsignales, so dass die Induktion (B) der Induktionseinstellung entspricht.

4. Vorrichtung nach Anspruch 1, bei welcher die Berechnungseinrichtung (30) eine Einrichtung (62) zum Subtrahieren eines Referenz-Energieverlustwertes von der sich ergebenden Leistung aufweist.

5. Vorrichtung nach Anspruch 1, welche weiterhin aufweist:
ein Messgerät (32), welches mit der Berechnungseinrichtung (30) verbunden ist, um eine Ablesung anzuzeigen, die für die resultierende Leistung repräsentativ ist.

6. Vorrichtung nach Anspruch 1, bei welcher die Abschnitte (14, 16, 18) der Sonde (8) eine Zahl von übereinander gelagerten Lamellen (26) aufweist, die gegeneinander elektrisch isoliert sind.

7. Vorrichtung nach Anspruch 1, bei welcher die End- bzw. Seitenflächen (17, 18) der Klauenabschnitte (16, 18) eine Mitte-zu-Mitte-Distanz aufweisen, die im Wesentlichen einer Mitte-zu-Mitte-Distanz zwischen den Zähnen (4) des Zahnpaares entspricht.

8. Vorrichtung nach Anspruch 1, bei welcher die Zähne (4) eine vorbestimmte Breite haben und die Endflächen (17, 19) der Klauenabschnitte (16, 18) eine Breite aufweisen, die kleiner als die Breite der Zähne (4) ist.

9. Vorrichtung nach Anspruch 1, bei welcher die Endflächen (17, 19) der Klauenabschnitte (16, 18) mit elektrisch isolierenden Abstandselementen (82,) versehen sind, die geeignet sind, gegen die Zähne (4) jedes Zahnpaares anzuliegen, um eine Spaltbreite zwischen der Sonde (8) und den Zähnen (4) des Zahnpaares fest einzustellen, wenn die Sonde (8) sich in ihrer Betriebsstellung befindet.

10. Vorrichtung nach Anspruch 1, bei welcher die Abschnitte (14, 16, 18) der Sonde (8) im Wesentlichen zusammen eine C-förmige Konfiguration aufweisen.

11. Vorrichtung nach Anspruch 1, bei welcher die Endflächen (17, 19) der Klauenabschnitte (16, 18) gegenüber den Hauptachsen der Klauenabschnitte (16, 18) verjüngt bzw. abgeschrägt sind.

12. Vorrichtung nach Anspruch 1, bei welcher die Mess- und Berechnungseinrichtung (24, 26, 30) durch einen Schaltkreis gebildet sind, welcher aufweist:
einen ersten Analog/Digital-Konverter (68), der einen Eingang aufweist, der mit der Erregerwicklung (20) verbunden ist, sowie einen Ausgang; einen zweiten Analog/Digital-Konverter (70) mit einem Eingang, der an die Messwicklung (22) angeschlossen ist, und einen Ausgang;
einen Mikrocontroller (66), der erste und zweite Eingänge aufweist, die jeweils mit den Ausgängen der Analog/Digital-Konverter (64, 70) verbunden sind, und einen Ausgang, um ein Signal zu erzeugen, welches für die resultierende Leistung repräsentativ ist.

13. Vorrichtung nach Anspruch 2, bei dem die Mess- und Berechnungseinrichtung (24, 26, 30), die Erregerquelle (12) und die Kontrolleinrichtung (38) durch eine Schaltung vorgesehen sind, welche aufweist:
einen ersten Analog/Digital-Konverter (68) mit einem Eingang, der an die Erregerwicklung (20) angeschlossen ist, und mit einem Ausgang; einen zweiten Analog/Digital-Konverter (70) mit einem Eingang, der mit der Messwicklung (22) verbunden ist, und mit einem Ausgang;
einen Mikrocontroller (66), der einen ersten und zweiten Eingang aufweist, die jeweils an die Ausgänge der Analog/Digital-Konverter (68, 70) angeschlossen sind, sowie einen dritten Eingang zum Empfang von Stellsignalen, einen ersten Ausgang, um ein Signal zu liefern, welches repräsentativ ist für die resultierende Leistung und einen zweiten Ausgang, um ein Digitalsignal zu erzeugen, welches repräsentativ ist für das Wechselstromsignal; und
einen Digital/Analog-Konverter und eine Verstärkerschaltungsanordnung (72, 74) mit einem Eingang, der an den zweiten Ausgang des Mikrocontrollers (66) angeschlossen ist, und mit einem Ausgang zur Lieferung eines Wechselstromsignals.

14. Vorrichtung nach Anspruch 13, die weiterhin aufweist:
ein Messgerät (32), welches mit dem ersten Ausgang des Mikrocontrollers (66) verbunden ist, um eine Ablesung anzuzeigen, die für die resultierende Leistung repräsentativ ist, und
eine Tastatur (78), die mit dem dritten Eingang des Mikrocontrollers (66) verbunden ist, um die Stellsignale zu erzeugen.

15. Verfahren zur Auswertung eines Zustandes eines Magnetkreises einer elektrischen Maschine, wobei der Magnetkreis eine Fläche (86) aufweist, die mit einer Serie von zueinander beabstandeten vorspringenden Zähnen (4) versehen ist, wobei das Verfahren folgende Schritte ausweist:
Positionierung einer Sonde (8) vor einem Paar von Zähnen (4), wobei die Sonde (8) einen magnetischen Querabschnitt bzw. Bügel (14) aufweist, erste und zweite zueinander beabstandete magnetische Klauenabschnitte (16, 18), die-von dem Querabschnitt (14) auf einer seiner Seiten von diesem wegstehen,
eine Erregerwicklung (20), die um den ersten Klauenabschnitt (16) gewickelt ist, und eine Messwicklung (22), die um den zweiten Klauenabschnitt (18) gewickelt ist, wobei die Klauenabschnitte (16, 18) jeweils Endflächen (17, 19) aufweisen, die so ausgelegt sind, dass sie mit den Zähnen (4) des Paares von Zähnen zusammenpassen, wobei die Endflächen (17, 19) in Ausrichtung zu den Zähnen (4) des Zahnpaares stehen bzw. in Flucht mit denselben stehen;
Erregen der Erregerwicklung (20) zur Induzierung eines Magnetflusses in einer Testzone (6), die durch die Zähne (4) des Zahnpaares und einen Abschnitt des Magnetkreises, der sich zwischen Letzteren erstreckt, gebildet ist;
Messen eines Stromes, der in der Erregerwicklung (20) fließt;
Messen einer Spannung über der Messwicklung (22); und
Berechnung einer resultierenden Leistung aus dem Strom und der Spannung, wobei die resultierende Leistung indikativ ist für den Zustand der Testzone.

16. Verfahren nach Anspruch 15, welches den folgenden Schritt aufweist:
Vergleichen der resultierenden Leistung mit einem Referenzleistungswert, um einen Fehlerzustand in der Testzone (6) zu bestimmen.

17. Verfahren nach Anspruch 16, bei dem der Bezugsleistungswert durch Berechnung einer typischen Leistung bestimmt wird, die erwartet wird als Funktion der physikalischen Charakteristiken des Magnetkreises und der Sonde (8).

18. Verfahren nach Anspruch 16, bei welchem der- Bezugsleistungswert durch Durchführung des Verfahrens vor dem ersten Gebrauch des Magnetkreises bestimmt wird.

19. Verfahren nach Anspruch 15, bei welchem die Schritte für alle Zähne (4) des Magnetkreises wiederholt werden, um mögliche Fehlerabschnitte desselben zu lokalisieren.

20. Verfahren nach Anspruch 19, bei welchem die Erregerquelle (12) so eingestellt wird, um einen Magnetfluss zu induzieren, der eine konstante Amplitude in jeder Testzone (6) aufweist.

## Revendications

1. Un appareil pour évaluer un état d'un circuit magnétique d'une machine électrique, le circuit magnétique ayant une face (86) dotée d'une série de dents (4) saillantes espacées, l'appareil comprenant:
une sonde (8) ayant une partie magnétique transversale (14), des première et deuxième branches magnétiques espacées (16, 18) se projetant de la partie transversale (14) sur un côté de la partie transversale (14), un bobinage d'excitation (20) enroulé autour de la première branche (16), et un bobinage de mesure (22) enroulé autour de la deuxième branche (18), les branches (16, 18) ayant des faces terminales respectives (17, 19) adaptées pour concorder avec une paire desdites dents (4) avec les faces terminales (17, 19) en alignement avec les dents (4) de ladite paire;
une source d'excitation (12) électriquement connectée au bobinage d'excitation (20);
un moyen de mesure de courant (26) pour mesurer un courant circulant dans le bobinage d'excitation (20);
un moyen de mesure de tension (24) pour mesurer une tension à travers le bobinage de mesure (22); et
un moyen de calcul (30) pour calculer une puissance résultante à partir des courant et tension mesurés par les moyens de mesure (24, 26), la puissance résultante étant indicative de l'état d'une zone en test (6) formée des dents (4) de ladite paire et une partie du circuit magnétique s'étendant entre les dents (4).

2. L'appareil selon la revendication 1, dans lequel la source d'excitation (12) a une sortie pour produire un signal AC ayant une tension, l'appareil comprenant de plus un moyen de contrôle (38) pour contrôler la tension du signal AC en fonction de la tension à travers le bobinage de mesure (22).

3. L'appareil selon la revendication 2, dans lequel le moyen de contrôle (38) comprend:
un moyen de comparaison (44) pour comparer une induction B dans la sonde (8) avec une consigne d'induction, l'induction B étant exprimée comme B=V/mSf où V est la tension à travers le bobinage de mesure (22), m est un nombre de tours du bobinage de mesure (22) autour de la deuxième branche (18), S est une section de la deuxième branche (18), et f est une fréquence du signal AC; et
un moyen d'ajustement (46) répondant au moyen de comparaison (44), pour ajuster la tension du signal AC de sorte que l'induction B corresponde à la consigne d'induction.

4. L'appareil selon la revendication 1, dans lequel le moyens de calcul (30) comprend un moyen (62) pour soustraire une valeur de pertes de puissance de référence de la puissance résultante.

5. L'appareil selon la revendication 1, comprenant de plus un compteur (32) connecté au moyen de calcul (30) pour afficher une lecture représentative de la puissance résultante.

6. L'appareil selon la -revendication 1, dans lequel la partie et les branches (14, 16, 18) de la sonde (8) comprennent un nombre de tôles superposées (76) isolées électriquement les unes des autres.

7. L'appareil selon la revendication 1, dans lequel les faces terminales (17, 19) des branches (16, 18) ont une distance centre-à-centre correspondant substantiellement à une distance centre-à-centre entre les dents (4) de ladite paire.

8. L'appareil selon la revendication 1, dans lequel les dents (4) ont une épaisseur prédéterminée, et les faces terminales (17, 19) des branches (16, 18) ont une épaisseur plus petite que l'épaisseur des dents (4).

9. L'appareil selon la revendication 1, dans lequel les faces terminales (17, 19) des branches (16, 18) sont dotées de pièces d'espacement électriquement isolants (82) adaptés pour s'appuyer contre les dents (4) de ladite paire pour fixer une épaisseur d'entrefer entre la sonde (8) et les dents (4) de ladite paire lorsque la sonde (8) est en position de fonctionnement.

10. L'appareil selon la revendication 1, dans lequel la partie et les branches (14, 16, 18) de la sonde (8) ont généralement ensemble une configuration en forme de "C".

11. L'appareil selon la revendication 1, dans lequel les faces terminales (17; 19) des branches (16, 18) sont biseautées par rapport à des axes principaux des branches (16, 18).

12. L'appareil selon la revendication 1, dans lequel les moyens de mesure et de calcul (24, 26, 30) sont réalisés par un circuit comprenant:
un premier convertisseur analogique-numérique (68) ayant une entrée connectée au bobinage d'excitation (20), et une sortie;
un deuxième convertisseur analogique-numérique (70) ayant une entrée connectée au bobinage de mesure (22), et une sortie; et
un microcontrôleur (66) ayant des première et deuxième entrées connectées respectivement aux sorties des convertisseurs analogiques-numériques (68, 70), et une sortie pour produire un signal représentatif de la puissance résultante.

13. L'appareil selon la revendication 2, dans lequel les moyens de mesure et de calcul (24, 26, 30), la source d'excitation (12) et le moyen de contrôle (38) sont réalisés par un circuit comprenant:
un premier convertisseur analogique-numérique (68) ayant une entrée connectée au bobinage d'excitation (20), et une sortie;
un deuxième convertisseur analogique-numérique (70) ayant une entrée connectée au bobinage de mesure (22), et une sortie;
un microcontrôleur (66) ayant des première et deuxième entrées connectées respectivement aux sorties des convertisseurs analogiques-numériques (68, 70), une troisième entrée pour recevoir des signaux de consigne, une première sortie pour produire un signal représentatif de la puissance résultante, et une deuxième sortie pour produire un signal numérique représentatif du signal AC; et
un arrangement convertisseur numérique-analogique et circuit amplificateur (72, 74), ayant une entrée connectée à la deuxième sortie du microcontrôleur (66), et une sortie pour produire le signal AC.

14. L'appareil selon la revendication 13, comprenant de plus:
un compteur (32) connecté à la première sortie du microcontrôleur (66) pour afficher une lecture représentative de la puissance résultante; et
un clavier (78) connecté à la troisième entrée du microcontrôleur (66), pour générer les signaux de consigne.

15. Une méthode pour évaluer un état d'un circuit magnétique d'une machine électrique, le circuit magnétique ayant une face (86) dotée d'une série de dents (4) saillantes espacées, la méthode comprenant les étapes de:
placer une sonde (8) en face d'une paire desdites dents (4), la sonde (8) ayant une partie transversale magnétique (14), des première- et deuxième branches magnétiques espacées (16, 18) se projetant de la partie transversale (14) sur un côté de la partie transversale (14), un bobinage d'excitation (20) enroulé autour de la première branche (16), et un bobinage de mesure (22) enroulé autour de la deuxième branche (18), les branches (16, 18) ayant des faces terminales (17, 19) respectives adaptées pour concorder avec les dents (4) de ladite paire avec les faces terminales (17, 19) en alignement avec les dents (4) de ladite paire;
exciter le bobinage d'excitation (20) pour induire un flux magnétique dans une zone en test (6) formée des dents (4) de ladite paire et une partie du circuit magnétique s'étendant entre les dents (4);
mesurer un courant circulant dans le bobinage d'excitation (20);
mesurer une tension à travers le bobinage de mesure (22); et
calculer une puissance résultante à partir du courant et de la tension, la puissance résultante étant indicative de l'état de la zone en test.

16. La méthode selon la revendication 15, comprenant de plus les étapes de:
comparer la puissance résultante avec une valeur de puissance référence pour déterminer un état de défaut dans la zone en test (6).

17. La méthode selon la revendication 16, dans laquelle la valeur de puissance référence est déterminée en calculant une puissance typique à s'attendre en fonction de caractéristiques physiques du circuit magnétique et de la sonde (8).

18. La méthode selon la revendication 16, dans laquelle la valeur de puissance référence est déterminée en réalisant la méthode avant une première utilisation du circuit magnétique.

19. La méthode selon la revendication 15, dans laquelle les étapes sont répétées pour toutes les dents (4) du circuit magnétique pour localiser des parties défectueuses possibles du circuit magnétique.

20. La méthode selon la revendication 19, dans laquelle la source d'excitation (12) est ajustée pour induire un flux magnétique ayant une amplitude constante dans chaque zone en test (6).
